# EUROPEAN PATENT APPLICATION

(11) **EP 1 657 747 A1**
(43) Date of publication of application: **17.05.2006**
(21) Application number: 04026850.0
(22) Date of filing: 11.11.2004
(51) Int. Cl.: H01L 23/26

(54) **Method of manufacturing highly moisture-sensitive electronic device elements**

(71) Applicant: SÜD-CHEMIE AG, 80333 München (DE)
(72) Inventor: The designation of the inventor has not yet been filed
(74) Representative: Westendorp, Michael Oliver

(57) **Abstract**

The invention relates to a method of manufacturing a highly moisture-sensitive electronic device elements containing microelectronic elements (2) in a hermetically sealed encapsulation enclosure (8), comprising the steps of:
- providing a substrate (1);
- providing a sealing member (6) which may form together with the substrate (1) a hermetically sealed encapsulation enclosure (8);
- placing micro-electronic elements (2) including at least one highly moisture-sensitive micro-electronic element (5) on the substrate (1);
- placing a desiccant material (9) on at least a portion of internal surfaces of the encapsulation enclosure (8);
- hermetically sealing the electronic device element by bonding the substrate (1) to the sealing member (6) such that the micro-electronic elements (2) are placed in a water-tight encapsulation enclosure (8); wherein
- the desiccant material (9) is activated by exposing the desiccant material (9) to microwave radiation of a wavelength/frequency that is absorbed by water molecules;

## Description

The invention relates to a method of manufacturing highly moisture-sensitive electronic device elements.

Typical electronic device elements require humidity levels in a range of about 2.500 to about 5.000 parts per million (ppm) to prevent premature degradation of device performance within a specified operating and/or storing life of the device. Control of the environment to this range of humidity levels within a packaged device is typically achieved by encapsulating the device together with a desiccant. Desiccants such as, for example, molecular sieve materials or silica gel materials are used to maintain the humidity level within the above range.

Particularly highly moisture-sensitive electronic device elements, for example, organic light-emitting devices (OLED) or panels, polymer light-emitting devices, charge-coupled device (CCD) sensors, and micro-electro-mechanical sensors (MEMS) require humidity control to levels below about 1.000 ppm and some require humidity control below even 100 ppm. Molecular sieve materials can achieve humidity levels below 1.000 ppm within an enclosure if dried at a relatively high temperature.

It is almost impossible to prevent moisture from diffusing through the seals of a hermetic enclosure such that the interior of the electronic device element is void of water vapour during the whole lifetime of the electronic device. To minimize the amount of moisture present in the inside of an encapsulation enclosure containing microelectronic elements, thereby enlarging the lifetime of the electronic device, desiccant materials usually are provided in the inside of the enclosure containing the moisture-sensitive micro-electronic elements. Such desiccant materials usually are enclosed in the interior in the form of tablets or granules or are deposited on the interior surfaces of the enclosure in the form of a thin film. Further, the desiccant may be entrained in a polymer film.

EP 1 014 758 A2 discloses an organic electroluminescent device comprising a substrate, an organic electroluminescent structure formed on the substrate, and a sealing member enclosing the organic electroluminescent structure for providing a seal thereto. On the inside surface of the sealing member is disposed a mixture of a desiccant and a high molecular weight organic compound, said mixture having a water absorption of up to 1.0 % as measured at 23 °C for 24 hours according to ASTM D570.

US 2002/0090531 A1 discloses an organic luminescence device, comprising an organic luminescence lamination structure comprising a pair of an anode and a cathode, and at least one organic compound layer disposed between the anode and the cathode. The organic luminescence lamination structure is enclosed in a hermetic sealing housing to block access of external air. Within the sealing housing is disposed a drying agent, wherein the drying agent comprises an organic isocyanate compound. The isocyanate may react with water vapour diffusing into the sealing housing thereby absorbing moisture.

US 5,591,379 describes a composition of matter having moisture gettering properties and applicable as coating or adhesive in a hermetic microelectronic device. The composition is applied to the interior surface of the packaging and comprises a desiccant finely dispersed in a binder which is a water vapour permeable solid material. The binder may be a polymer, porous ceramic or glass. Molecular sieves are especially useful as the desiccant component of the composition.

US 6,226,890 discloses a method of desiccating an environment surrounding a moisture sensitive electronic device sealed within an enclosure. The desiccant is comprised of solid particles having a particle size range of 0.1 to 200 micrometers. The desiccant particles are comprised in a binder. The binder may be in the liquid phase or dissolved in a liquid. A castable blend including at least the desiccant particles and the binder is formed, said blend having a preferred weight fraction of the desiccant particles in a range of 10% to 90 %. The blend is cast onto a portion of an interior surface of the enclosure to form a desiccant layer there over and is then solidified to a solid.

US 2003/0037677 A1 discloses a desiccant for use in a package which has a material including at least in part solid particles of one or more materials, at least one of such materials having an average particle size range of 0.001 to 0.1 micrometers to provide a high rate of water absorption and to provide an equilibrium minimum level lower than a humidity level to which a highly moisture sensitive electronic device is sensitive within a sealed enclosure.

During manufacture of electronic device elements the desiccant material is either used already in an "activated form", i.e. is used in a form, which does not need any further activation to achieve maximum water absorbency. This usually applies to desiccants which bound water vapour by an "irreversible" chemical reaction. Desiccants physically absorbing moisture may be activated after their deposition on interior surfaces of the enclosure. This activation is usually done by heating the desiccant to temperatures of more than about 500 °C to desorb bound water molecules. To avoid damage of the desiccant material the binder material used to bind the desiccant to a substrate has to be selected to withstand the temperatures used. During manufacturing of electronic devices usually the desiccant material is first placed on a substrate and the substrate is then heated together with the desiccant material for activation. However, in some instances it would be of advantage to perform the activation step close to the end of the manufacturing of the electronic device, i.e. immediately before sealing the electronic device. Should microelectronic elements already be placed on the substrate, also the micro-electronic elements have to withstand the temperatures used for activation.

WO 98/17711 discloses a process for the enhancement of the desiccating capacity of a desiccant polymer which includes the step of exposing the polymer to electromagnetic radiation of a wavelength/frequency that is absorbed by water molecules. The process may be applied to an industrial scale, e.g. to a large number of solid bodies of the desiccant polymer, e.g. vial stopper used for the package of moisture-sensitive pharmaceuticals, thin films, coatings etc. of the polymer. However, WO 98/17711 makes no reference to electronic devices.

OLEDs using zeolite based moisture getters have been proven to surpass the performance of OLEDs using other chemical based getters. This is due to the low levels of moisture attained by zeolites and also their ability to absorb oxygen in addition to moisture.

Recently dispensible pastes of zeolites have been developed for use in OLEDs. These overcome several disadvantages of sheet getters, which come in limited shapes and sizes, and also have restrictions on the largest available/ handleable size.

A big disadvantage of these dispensible pastes was the neccessity to bake them at extremely high temperatures for extended periods of time, typically a few hours, in order to activate the zeolite.

It is desirable to have electronic devices having a long life time wherein the functions of the electronic devices should not deteriorate during the life time. OLED's for example, should not develop "dark spots" thereby reducing the brightness e.g. of an OLED-display.

Accordingly, it is an object to the invention to provide a method of manufacturing highly moisture-sensitive electronic device elements containing microelectronic elements in a hermetically sealed encapsulation enclosure, which have a long lifetime and which show no deterioration of their functions even after a long time of use.

The object is solved by a method according to claim 1. Preferred embodiments of the method according to the invention are defined in the depending claims.

The method according to the invention comprises the steps of:
- providing a substrate
- providing a sealing member which may form together with the substrate a hermetically sealed encapsulation enclosure;
- placing micro-electronic elements including at least one highly moisture-sensitive micro-electronic element on the substrate;
- placing a desiccant material on at least a portion of internal surfaces of the encapsulation enclosure;
- hermetically sealing the electronic devices by bonding the substrate to the sealing member such that the micro-electronic elements are placed in a water-tight encapsulation enclosure; wherein
- the desiccant material is activated by exposing the desiccant material to microwave radiation of a wavelength/frequency that is absorbed by water molecules.

In the method according to the invention the desiccant material prior to sealing the encapsulation enclosure is activated by exposing the desiccant material to microwave radiation of a wavelength/frequency that is absorbed by water molecules. It has been found that by this additional activating step the absorbing capacity of the desiccant may be enhanced and therefore the lifetime of the electronic device may be prolonged. Further, by the use of microwave energy it is not necessary to heat the desiccant material to high temperatures for activation. Therefore, under certain circumstances it even may be possible to place micro-electronic elements on the substrate before activation of the desiccant material as the thermal load imposed on the electronic device and its components is reduced.

This invention removes the last hurdle in the adoption of desiccant pastes, preferably zeolite paste based getters, by making it possible to activate the desiccant, preferably the zeolite, at low temperatures in a short time.

The substrate may be made of any suitable organic or inorganic material or any combination of such materials of which electronic devices usually are fabricated. Such materials may be e.g. glass, ceramics, silicon or a organic or inorganic polymer. Preferably the substrate is a glass plate, a silicon wafer or a foil made from an organic polymer. Preferably the substrate is made of a plastic material, i.e. from organic polymers. Such organic polymers do not have to withstand high temperatures when used to provide a substrate in the method according to the invention. Preferably, such organic polymers have to withstand temperatures of not more than 200°C. Preferable plastic materials are based on polyacrylate, polyethylene, LCP (Liquid Crystal Polymer). Usual additives may be added to thee polymers.

Further, a sealing member is provided, which may form together with the substrate a hermetically sealed encapsulation enclosure. The sealing member may be made of any suitable organic or inorganic material or any combination of such materials and may comprise a single part, e.g. a glass plate, or may comprise several parts, e.g. a glass plate and several spacers arranged around the edges of the glass plate between the glass plate and the substrate.

The substrate and the sealing member may have any form. For OLED devices the substrate may have a flat even form, e.g. the form of a rectangle. However, in other applications a different shape of the substrate and the sealing member may be used. The substrate, for example, may have the form of a cube. On the substrate are placed one or more micro-electronic elements. The micro-electronic elements are deposited by methods known to the skilled person from the manufacturing of microelectronic devices. The micro-electronic elements comprise all usual elements, e.g. cathodes, anodes, transistor elements, capacitors, diodes, and so on. The micro-electronic elements deposited on the substrate include at least one highly moisture-sensitive electronic element. Such a highly moisture-sensitive element may be e.g. a liquid-crystal element or an OLED.

The desiccant material is placed within a small area on at least a portion of an interior surface of the encapsulation enclosure. There are no restrictions as to the surface on which the desiccant material is placed as long as such deposition has no harmful effect on the electronic device element. The desiccant material may be deposited on the substrate and/or the micro-electronic elements and/or the sealing member. There are no restrictions as to the method of placing the desiccant material on the interior surface. Further, there are no restrictions as to the form the desiccant material is placed in the interior of the encapsulation enclosure. The desiccant material may e.g. have the form of a tablet or may be deposited on the surface in the form of a thin film. Such a film may be formed e.g. from a desiccant entrained polymer. There may be provided a cavity on the inside surface of the encapsulation enclosure which may be filled with the desiccant material. There is also no restriction on the shape of the deposition. It could be a planar deposition on one surface, or the desiccant could be deposited along the periphery of the device, so it is located next to the adhesive sealant.

The desiccant material may comprise every known organic or inorganic desiccant. Suitable desiccants are alkali metal oxides and alkaline earth metal oxides, e.g. sodium oxide (Na₂O), potassium oxide (K₂O), Calcium oxide (CaO), Barium oxide (BaO), magnesium oxide (MgO), sulfates, halides, perchlorates and hydrides of alkali and alkali earth metals, e.g. sodium hydride (NaH) which absorb moisture by chemically reacting with the water. Further desiccant materials to be used in the method according to the invention are desiccant materials which physically absorb water. Suitable desiccants are e.g. molecular sieves, zeolites, activated silica, activated alumina. Organic desiccant materials may also be used in the method according to the invention, inorganic desiccant materials being preferred and physically absorbing desiccant material being further preferred. Preferred physically absorbing desiccant materials are selected from the group of zeolites, silica gel, fumed silica, and/or neutral or alkaline clays; zeolites being most preferred.

The desiccant material may comprise a single desiccant or may be a combination of several desiccants. When several desiccants are used those may form a homogenous mixture, a composite material, or multiple layers of desiccants. The desiccant may be entrained in a suitable binder material, e.g. an organic polymer. Polymers suitable as a binder material are e.g. polyethylene resins, polypropylene resins, polystyrene resins, polyvinyl chloride, polycarbonate resins as well as rubber materials. The polymer should be inert towards the desiccant. The desiccant entrained polymer may be deposited on the substrate or the sealing member e.g. in the form of a film.

The amount of binder may be selected within a broad range. In a mixture of desiccant and binder the desiccant may be contained in an amount of 10 to 90 wt.-%, preferably 60 to 90 wt.-% in the desiccant material.

The micro-electronic elements are hermetically sealed in an encapsulation enclosure by bonding the substrate to the sealing member such that the micro-electronic elements are placed in a water-tight encapsulation enclosure. The bonding of the substrate to the sealing cap may be achieved e.g. by a suitable adhesive or by any other method known in the manufacturing of electronic devices. A suitable adhesive is e.g. an epoxy resin.

The manufacturing steps explained hereinbefore are all common knowledge to the skilled person in the manufacturing of electronic device elements and are performed in the usual way.

To improve the properties of the electronic device elements obtained by the method according to the invention the desiccant material is activated prior to sealing the encapsulation enclosure. The activation of the desiccant material is performed by exposing the desiccant material to microwave radiation of a wavelength/frequency that is absorbed by water molecules. It has been found that by exposing the desiccant material to microwave radiation of an appropriate wavelength, the moisture uptake capacity of the desiccant material can be significantly improved. Without wishing to be bound by theory it is assumed that by exposing the desiccant material to microwave radiation water molecules physically adhering to the desiccant material are removed. For compounds absorbing moisture in a chemical reaction it is assumed that by exposing to microwave radiation such water molecules are removed that have not yet reacted with the desiccant material.

The desiccant material may be activated at any time before sealing the encapsulation enclosure. The desiccating material may be placed on the substrate before or after placing the micro-electronic elements on the substrate. The desiccant material may be activated before placing it on an interior surface of the encapsulating enclosure or after deposition. The desiccant material may even be exposed to the microwave radiation after joining the substrate and a sealing cap for forming an encapsulating enclosure. In the latter case a small vent hole has to be provided in the substrate or the sealing cap to remove moisture desorbed from the desiccant material by microwave treatment. After the activation of the desiccant material the vent hole is sealed by an appropriate sealing material.

According to a further embodiment the desiccant material is activated by microwave radiation before placing it on an inside surface of the encapsulation enclosure.

The microwave activation may be performed at a place close to where the highly moisture sensitive electronic device element is manufactured such that the activated desiccant material may be placed on an area of the interior surface of the encapsulation enclosure immediately after activation. However, it is also possible to perform the microwave activation at a place physically away from the other components of the encapsulation. Further, it is also possible to deposit the desiccant material on a part of the encapsulation enclosure, e.g. the substrate, at a first place and, after microwave activation of the desiccant material, transport the substrate with the activated desiccant material to a second place, which is physically away from the first place, where the substrate is joined with the sealing member to form the encapsulation enclosure.

The process of microwave activation of the desiccant material and the sealing of the substrate and the sealing member to form an encapsulation enclosure may be performed in a single chamber, in separate chambers connected to each other through a passage, or in any other continuous process.

According to a further embodiment the desiccant material is first placed on a substrate and/or sealing member. Several of the desiccant coated substrates and/or sealing members are then stacked into a cassette. The entire cassette is then subjected to microwave radiation.

During microwave activation the cassette is preferably ventilated to drive away the moisture.

The cassette does not have to withstand high temperatures during activation of the desiccant material. The cassette may be made from a material that cannot withstand temperatures above 200°C, e.g. a plastic material.

After the microwave activation the substrate and/or sealing member coated with the desiccant material, or the cassette containing the substrates and/or sealing members coated with the activated desiccant material may be enclosed in a moisture barrier envelope for transportation to a site where the encapsulation enclosure is produced.

According to a further embodiment the cassette is placed into a glove box after microwave activation, e.g. to remove the substrates and/or sealing members from the cassette for further processing.

The microwave activation of the desiccant material preferably is performed under vacuum or an inert gas. A preferred inert gas is nitrogen.

Preferably the amount of time the desiccant material is exposed to the microwave radiation is less than or equal to the cycle time of the encapsulation process multiplied by the number of microwave treatment workstations feeding to the encapsulation workstation.

Preferably the time interval between activation of the desiccant material and the sealing of the encapsulation enclosure is selected to be less than 10 minutes.

Depending on the binder material the desiccant may be activated before or after mixing it with a binder material. With the usual binder materials the desiccant material is preferably activated after mixing.

If water or a water containing liquid is used to deposit the desiccant material on the inside surface of the encapsulation enclosure, e.g. to form a thin film of the desiccant material, the activation step is performed after placing the desiccant material on an inside surface of the encapsulation enclosure.

To assist removal of the desorbed water vapour the activation step may be performed at reduced pressure and/or elevated temperature. Preferably the activation step is performed at a temperature of less than 300°C, preferably less than 200 °C. Suitably the reduced pressure is selected in a range of less than 100 hPa, preferably within a range of 10⁻³ to 10 hPa.

The amount of energy applied per gram of the desiccant material is preferably at least 100 W, most preferably selected within a range of 50 W to 5 kW.

Preferably, the desiccant material is used in the form of a fine powder having a mean particle size (D₅₀) of about 0.1 to 10 µm, preferably 2 to 8 µm, most preferred 3 to 6 µm, though not limited thereto. The mean particle size D₅₀ may be determined e.g. by laser granulometry. The mean particle size D₅₀ corresponds to a value in which 50 % of the particles have a size smaller than D₅₀ and 50 % of the particles have a size larger than D₅₀.

The desiccant material is deposited on the inside surfaces of the encapsulation enclosure in an amount sufficient to absorb moisture diffusing into the interior of the encapsulation enclosure during the lifetime of the electronic device. To avoid harmful influence of the desiccant material on the electronic device the desiccant material is preferably situated spaced from the micro-electronic element.

According to one embodiment of the method according to the invention the desiccant material is applied to the inside surface of the encapsulation enclosure in film form. An appropriate amount of the desiccant material is 0.001 to 0.5 g/cm², preferably 0.01 to 0.1 g/cm², preferably having a layer thickness of 1 µm to 1 mm, preferably between 5 µm to 1 mm, most preferred 15 µm to 200 µm. Any application technique may be used to form the film including e.g. roll coating, blade coating, brush coating and printing. The use of a dispenser is also acceptable.

The microwave radiation used to activate the desiccant material has a wave length that is absorbed by water molecules. Preferably the microwave radiation has a wavelength in a range of 1 mm to 15 cm (frequency 3 x 10¹¹ - 2 x 10⁹).

Exposure time and power level of the microwave radiation is selected to achieve maximum removal of water at minimal exposure time causing minimal damages e.g. to the binder and/or parts of the electronic device elements. Optimum wavelength, power level, exposure time and other conditions of the activation process can be determined by relatively easy experimentation. If the desiccant material already contains an (organic) binder or is already placed on an interior surface of the encapsulation enclosure, it is preferred to use lower microwave radiation power for a longer exposure time. If the desiccant material contains only inorganic compounds an activation by exposure to microwave radiation at higher power levels and shorter exposure time is preferred for economic reasons. Usually the exposure time is selected to be at least 1 minute.

The desiccant material may be exposed to the microwave radiation in a single cycle. Alternatively, the desiccant material may be exposed to the microwave radiation in a pulsed cycle, i.e. exposure of the desiccant material to the microwave radiation for a, usually short, period, followed by a resting phase during which the desiccant material is not exposed to the microwave radiation, followed, if necessary, by a further alternating exposure and resting phases. The rest cycle may contain a cooling process.

Suitable generators for microwave radiation and apparatus in which the desiccant material is activated are known to the skilled person. The microwave apparatus may have a facility to create vacuum.

The desiccant material may be used as such, i.e. without a binder, e.g. in the form of a compressed tablet or a granule. Preferably, the desiccant material comprises a binder material. Such binder material may be e.g. a organic polymer. As the microwave treatment of the desiccant material does not require application of high temperatures, a binder may be used having a thermostability of less than 200 °C. Appropriate organic binder materials have already been mentioned.

According to one embodiment of the method of the invention an inorganic binder material is used. The inorganic binder material preferably is a naturally occurring and/or a synthetic layered silicate.

It has been found that use of such naturally occurring and/or synthetic layered silicates allows manufacturing of films having high moisture absorbing activity. Preferably such films are formed without applying pressure and are preferably produced without adding any further adhesive.

By the use of a naturally occurring and/or synthetic layered silicate a porous matrix may be formed containing the desiccant material which at the same time firmly adheres to various support materials, i.e. materials of which the support or the sealing cap is made of. The desiccating properties are not influenced by the presence of the naturally occurring and/or synthetic layered silicate and in some cases are even improved. The naturally occurring and/or synthetic layered silicate may further act as a sorbent for sorption of polar or apolar compounds present in the interior of the encapsulating enclosure which also might have a harmful effect on the electronic devices. Two and three layered alumosilicates are preferred with smectitic layered silicates being especially preferred. A preferred smectitic layered silicate is bentonite, preferably in its sodium form. Besides the naturally occurring and/or synthetic layered silicates further binders may be used with the desiccant material. Such further binders preferably are inorganic binder materials. Preferred binder materials are alumino oxide hydroxide (Al(O)(OH)), pseudoboehmite, water glass, borates and low melting glasses. Those binders act to form a film on the inside surface of the encapsulation enclosure, to bind the particles of the desiccate material to each other and to the substrate and/or sealing member surface.

The naturally occurring and/or synthetic layered silicate is preferably used in form of particles to be mixed with a powdery desiccant. Preferred desiccants, e.g. zeolites, are available in form of a powder and have a moisture content of about 10 to 22 wt.-%. Preferred naturally occurring and/or synthetic layered silicates used as a binder in the method according to the invention, e.g. bentonites, are also available as a powder and usually have a moisture content of about 3 to 20 wt.-%, preferably 8 to 12 wt.-%. The moisture content may be measured by drying at 160 °C. The bentonite preferably contains > 80 wt-% montmorillonite (determined in the dry state).

The mean particle size (D₅₀) of the naturally occurring and/or synthetic layered silicate preferably is within a range of about 2 to 8 µm, most preferred 3 to 6 µm.

Preferably the naturally occurring and/or synthetic layered silicate comprises particles of a size of more than 250 µm, preferably more than 200 µm in an amount of not more than about 10 %, preferably not more than 5 wt.-%, most preferred not more than 0 wt.-%. The amount of particles having a size of not more than 250 µm, preferably more than 200 µm may be determined by sieve analysis.

According to a preferred embodiment of the method according to the invention the naturally occurring and/or synthetic layered silicate preferably has a swellability of at least 15 ml/2 g, preferably within a range of 20 ml/2 g to 40 ml/2 g. Without wishing to be bound by that theory the inventor assumes that by the swellablility of the layered silicate the porosity of the matrix and the adherence towards a substrate and/or sealing member is improved.

The average pore size (4V/A by BET) of the layered silicate preferably is within a range of 3 to 15 nm, most preferred 4 to 12 nm. According to a preferred embodiment the layered silicate contains about 30 to 130 meq/100 g Na⁺, determined by ion exchange.

According to a preferred embodiment the desiccant material, before placing it on an inside surface of the encapsulating enclosure, essentially comprises the desiccant, the layered silicate and a liquid. The liquid is used to form a paste or a slurry containing the desiccant and the layered silicate. A preferred liquid is water. It is also possible to use mixtures of liquids, e.g. a mixture of water and an alcohol. The amount of liquid added to the desiccant material and the layered silicate preferably is within a range of 10 to 80 wt.-%. When using water as a liquid to form a paste or a slurry the activation of the desiccant material by exposure to microwave radiation is performed after placing the desiccant material on an inside surface of the encapsulating enclosure. After removal of the liquid the desiccant material film essentially contains the desiccant and the layered silicate.

The desiccant material may contain further usual additives known to the skilled person. Such additives are e.g. flowing agents, sinter additives, pigments and preservatives.

According to a preferred embodiment the desiccant material is coated onto the substrate and/or sealing member in the form of, preferably rectangular, areas. After microwave activation or after additional manufacturing steps, e.g. formation of the encapsulation enclosure, the substrate and/or sealing member is divided into smaller pieces to obtain separate devices.

According to a still more preferred embodiment the microwave radiation is focussed so that only the desiccant coated areas are exposed to the microwave radiation whereas the uncoated areas in between, which may have other coatings, such as adhesives, are shielded from the microwaves.

The method according to the invention avoids high temperatures and may be performed within a short period of time, e.g. few minutes. Therefore the desiccant material may be activated immediately before placing it into the interior of a electronic device element, i.e. the activating step may be performed in the production line of the manufacturer of the electronic device element. The desiccant material may be produced at the site of the desiccant maker and may be e.g. placed on a glass lid, that forms the back panel of the electronic device element. Immediately before joining the substrate and the glass lid to obtain an encapsulation enclosure for the micro-electronic elements, the desiccant material is activated by exposure to microwave radiation thereby achieving a longer life span of the electronic device.

According to a further aspect of the invention an apparatus is provided comprising
- a sample holder for holding a substrate or sealing member onto which a desiccant material is provided;
- a microwave radiation source focused on a location where the desiccant material is provided.

According to a preferred embodiment the apparatus further comprises:
- a suction device aimed at the area where the desiccant material is provided to suck away moisture liberated from the desiccant material.

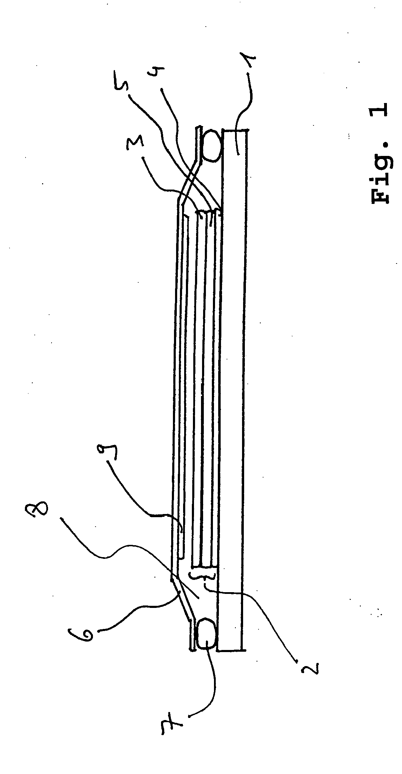

The invention will now be described by way of non-limiting example only, with reference to the accompanying drawing, fig. 1, which schematically displays an electronic device obtained by the method according to the invention.

### Methods:

The viscosity of pastes and slurries were determined according to DIN 53019/ISO 3219 using a Rheo-Stress 600 Rheometer available from Hake Company, Germany, according to the instructions of the manufacturer.

### The swellablility was determined as follows:

A 100 ml graduated glass cylinder was filled with 100 ml of distilled water. 2.0 g of the compound of interest were slowly deposited on the water surface in 0.1 g to 0.2 g portions. After descending of a portion the next portion was deposited on the water surface. 1 hour after addition of the complete amount of the compound the volume of the swollen compound is determined in ml/2 g.

The BET-surface was determined according to DIN 66131. The porosimetry was determined according to the pore size average pore diameter (4V/A) by BET).

The particle size was determined with a Mastersizer S Ver. 2.17 (Malvern Instruments GmbH, Herrenberg, Germany) according to the instructions by the manufacturer.

The ion exchange capacity (IEC) was determined according to the ammonium chloride method:
A 5 g sample was sieved through a 63 µ-sieve and dried at 110 °C. Then, exactly 2 g of the sample were weighed in an Erlenmeyer-flask with standard taper-ground joint and 100 ml of a 2N NH₄Cl solution were added. The suspension was boiled under reflux for 1 hour. After a waiting time of 16 h the bentonite was filtered off and thoroughly washed with deionised water (about 800 ml). The test for absence of NH₄-ions was performed with Nessler's reagent (Merck KGaA, Germany, Art. No. 9028). Depending on the clay the washing time may vary between 30 minutes and 3 days. The washed NH₄-bentonite was dried for 2 hours at 110 °C, ground, sieved (63 µm-sieve) and dried for a further 2 hours at 110 °C. Then the NH₄-content of the bentonite was determined according to Kjedahl. The IEC corresponds to the NH₄-amount determined according to

Kjedahl (meq/100 g clay).

The ions released by the exchange reaction are contained in the washing water and may be determined by AAS (atom absorption spectrometry). The washing water was reduced by boiling, then transferred into a 250 ml-flask and deionised water filled in up to the graduation. For sodium the following conditions were used:

| | |
|---|---|
| wavelength (nm) | 589,0 |
| width of slit (nm) | 0,2 |
| integr. time (s) | 3 |
| flame gases | air/C₂H₂ |
| background compensation | no |
| mode of measuring | conc. |
| ionisation buffer | 0.1 % KCl |
| standard (mg/l) | 1-5 |

The ICE is given in meq/100 g clay.

### Examples:

### Example 1

680 g of zeolite 4A (water content 11,9 %) were suspended in 2,5 1 of water followed by addition of 170 g bentonite (water content 9.3 %, Na-bentonite, D₅₀ = 4,4 µm). The mixture was dispersed under high-shearing conditions using a high shearing Ultra-Turrax®-mixer for 10 min.

### Example 2

680 g of zeolite 4A (water content 11,9 %) were suspended in 2,5 1 of water followed by addition of 120 g bentonite (water content 9.3 %, Na-bentonite, D₅₀ = 4,4 µm). The mixture was dispersed under high-shearing conditions using a high shearing Ultra-Turrax®-mixer for 10 min.

The viscosity of the samples was measured at shear rates of 1 s⁻¹, 10 s⁻¹, 100 s⁻¹, and 1.000 s⁻¹, (data in Pa*s) ;

| example | 1 | 2 |
|---|---|---|
| 1 s⁻¹ | 106 | 0.55 |
| 10 s⁻¹ | 9.6 | 0.14 |
| 100 s⁻¹ | 1.6 | 0.05 |
| 1.000 s⁻¹ | 0.19 | 0.03 |

After storage of the samples at 40°C for 6 weeks the syneresis was determined. The sample of example 1 did not show any syneresis, whereas the sample of example 2 showed a low syneresis (< 10 %).

The samples from examples 1 and 2 were placed with a pipette into glass cavities having a size of 45 mm x 29 mm x 0.4 mm. The samples were dried at room temperature and film formation as well as film adhesion were evaluated.

The samples obtained in both examples showed good film formation and adhered firmly to the glass support.

### Example 3

5 g of zeolite 4A were placed in a porcelain tray and placed in a 700 W microwave oven. The samples were exposed to microwave radiation for 2, 3, 4 and 5 minutes. The samples were taken out of the oven and placed in an desiccator for 15 min to cool to room temperature. The samples were then weighed again to calculate the theoretical water absorption capacity. The samples were then placed in a climatic chamber at 25 °C and 40 % r.h. (relative humidity). The samples were left for 12 hours and then taken out of the chamber and weighed again to determine the actual water absorption capacity achieved.

| exposure time (min) | Wt. after exposure (g) | Theoretical capacity | Wt. after exposure to humidity for 12 hours (g) | Actual capacity achieved |
|---|---|---|---|---|
| 2 | 4.29 | 16,6 % | 4.86 | 13.3 |
| 3 | 4.05 | 23.5 % | 4.86 | 20.0 |
| 4 | 3.92 | 27.6 % | 4.86 | 24.0 |
| 5 | 3.88 | 28.9 % | 4.87 | 25.5 |

### Example 4

695 mg of the paste obtained in example 1 were placed with a pipette into cavities having a size of 45 mm x 29 mm x 0.4 mm formed into a glass plate. The sample was placed in a 700 W microwave oven for 5 min. To obtain an OLED the glass substrate was fixed to a glass substrate to which micro-electronic elements were arranged to form the back panel of the electronic device. The electronic device is shown schematically in fig. 1. On a glass substrate 1 are placed micro-electronic elements 2 forming an OLED. Such electronic elements comprise a cathode 3, an anode 4 and an organic light emitting layer 5. A sealing cap 6 is placed on top of glass substrate 1. Substrate 1 and sealing cap 6 are joined to each other at their outer edges by an epoxy sealant 7 to form a water-tight encapsulation enclosure 8. On an interior surface of the encapsulation enclosure 8 a desiccant film 9 is placed on the inner surface of sealing cap 6.

The size of the light-emitting pixels was measured and the electronic device then stored for 500 h in a climatic chamber at 85 °C and 85 % r.h. The size of the light emitting pixels was again measured and the number of dark spots determined. It was found, that no dark spots appeared and that the size of the light-emitting pixels was the same as at the beginning of the experiment.

## Claims

1. Method of manufacturing a highly moisture-sensitive electronic device elements containing microelectronic elements (2) in a hermetically sealed encapsulation enclosure (8), comprising the steps of:
- providing a substrate (1);
- providing a sealing member (6) which may form together with the substrate (1) a hermetically sealed encapsulation enclosure (8);
- placing micro-electronic elements (2) including at least one highly moisture-sensitive micro-electronic element (5) on the substrate (1);
- placing a desiccant material (9) on at least a portion of internal surfaces of the encapsulation enclosure (8) ;
- hermetically sealing the electronic device element by bonding the substrate (1) to the sealing member (6) such that the micro-electronic elements (2) are placed in a water-tight encapsulation enclosure (8);
- wherein the desiccant material (9) is activated by exposing the desiccant material (9) to microwave radiation of a wavelength/frequency that is absorbed by water molecules;

2. Method according to claim 1 or 2, wherein the desiccant material (9) comprises a physically absorbing desiccant, preferably a zeolite.

3. Method according to claim 2, wherein the physically absorbing desiccant is selected from the group consisting of zeolites, silica gel, fumed silica, and/or neutral or alkaline clays.

4. Method according to one of the preceding claims, wherein the microwave radiation has a wavelength in a range of 1 mm to 15 cm.

5. Method according to one of the preceding claims, wherein the desiccant material is exposed to microwave radiation for at least 2 minutes.

6. Method according to one of the preceding claims, wherein the microwave radiation is applied at an energy of at least 100 W per gram of desiccant material.

7. Method according to one of the preceding claims, wherein the microwave radiation is focussed on the area where the desiccant material is present.

8. Method according to one of the preceding claims, wherein the desiccant material comprises a binder material.

9. Method according to claim 9, wherein the binder has a thermostability of less than 200 °C.

10. Method according to claim 9, wherein the binder material is a naturally occurring and/or a synthetic layered silicate.

11. Method according to one of the preceding claims, wherein the desiccant material is a mixture comprising:
- a desiccant;
- at least one naturally occurring and/or a synthetic layered silicate;
- a liquid;
said mixture is placed on at least a portion of interior surfaces of the encapsulation enclosure (8); and after placing the desiccant material the liquid is removed.

12. Method according to one of the preceding claims, wherein the desiccant material is placed in the form of a layer having a thickness of 1 µm to 1 mm, preferably between 5 µm to 1 mm, most preferred 15 µm to 200 µm.

13. Method according to one of the preceding claims, wherein the time between the activation of the desiccant material and the sealing of the electronic device element is less than 10 minutes.

14. Method according to one of the preceding claims, wherein the substrate and/or the sealing member is made of a plastic material.

15. Highly moisture-sensitive electronic device element containing microelectronic elements (2) in a hermetically sealed encapsulation enclosure (8) said electronic device element being obtainable by a method according to one of claims 1 to 18.

16. Apparatus, comprising
- a sample holder for fixing a substrate or a sealing member onto which a desiccant material is deposited
- a microwave radiation source focussed on a location where the desiccant material is provided.

17. Apparatus according to claim 20, further comprising
- a suction device aimed at an area where the desiccant material is provided to suck away moisture liberated from the desiccant material.
